# EUROPEAN PATENT APPLICATION

(11) **EP 2 800 131 A1**
(43) Date of publication of application: **05.11.2014**
(21) Application number: 13165780.1
(22) Date of filing: 29.04.2013
(51) Int. Cl.: H01L 21/603

(54) **Method for sinter bonding semiconductor devices**

(71) Applicant: ABB Technology AG, 8050 Zürich (CH)
(72) Inventor: Liu, Chunlei, 5406 Rütihof (CH); Brem, Franziska, 8700 Küsnacht (CH); Simon, Reinhard, 5405 Dättwil (CH)
(74) Representative: ABB Patent Attorneys

(57) **Abstract**

A method of bonding an electronics semiconductor device (12) to a substrate (14) comprises the steps of: depositing a layer (20) of metallic particles on a bonding area of the semiconductor device (12) and/or of the substrate (14); positioning the semiconductor device (12) on the substrate (14), such that the layer (20) is positioned between the semiconductor device (12) and the substrate (14);enclosing the semiconductor device (12) and the substrate (14) with a flexible bag (22); evacuating the interior of the bag (22) and sintering the semiconductor device (12) and the substrate (14) together by applying heat and pressure to the layer (20). The heat and the pressure are applied by a gas (44) that surrounds the flexible bag (22) which encloses the semiconductor device (12) and the substrate (14).

## Description

### Field of the invention

The invention relates to the field of manufacturing of electronic devices and packaging of electronic components. In particular, the invention relates to a method of bonding an electronics semiconductor device to a substrate.

### Background of the invention

In power electronics module assembly, the semiconductor chip is usually mechanically connected to the substrate by a soldering process. These soft solder interfaces may show several drawbacks concerning reliability due to their low melting point and creep properties. Furthermore, the trend towards higher power densities and operation temperatures in power electronics requires novel bonding solutions in order to fullfill the lifetime requirements of the various power electronic applications.

Silver (Ag) sintering is a novel low temperature bonding technique developed, e.g. for bonding a silicon chip to substrate in an advanced electronics packaging process. Compared to a conventionally soldered connection, a sintered connection may show much better electrical, thermal and mechanical properties, which may result in a higher power density capability, a higher operating temperature and a higher reliability.

However, silver sintering is not widely used in the electronic packaging industry up to now due to the specific processing. Both pressure (for example more than 10 MPa) and heat (around 200 to 350 °C) are needed during the sintering process. Usually, the silver sintering process is performed in sequence using a hydraulic press with an integrated heating plate (also called hot press) or in a batch process using a pressurized and heated oil bath.

Because heat and pressure must be maintained for several seconds to even minutes to achieve a sufficient sintering density, the throughput of a hot press process is limited. Furthermore, there is still high risk of chip or ceramic damage under this process if the pressure is not applied homogenously. A process using an oil bath is not a desired process for semiconductor manufacturing due to oil contamination and the necessity of an additional cleaning procedure. Furthermore, a batch process with an oil bath is in general not a clean room compatible process for semiconductor assembly due to oil contamination.

### Description of the invention

The object of the invention is to simplify and accelerate the sintering of components in a semiconductor module assembly.

This object is achieved by the subject-matter of the independent claim. Further exemplary embodiments are evident from the dependent claims and the following description.

The invention relates to a method of bonding an electronics semiconductor device to a substrate. The semiconductor device may be a semiconductor chip. The semiconductor device may be a high power electronics device like a diode, transistor, IGBT, etc. The substrate may be a support for the semiconductor device and may be adapted to provide electrical connections to the semiconductor device. In the case of a transistor, these electrical connections may be a gate contact, an emitter contact, and a collector contact.

According to an embodiment of the invention, the method comprises the steps of: depositing a layer of metallic particles on a bonding area of the semiconductor device and/or of the substrate and/or any other interface within the module; positioning the semiconductor device on the substrate, such that the layer is positioned between the semiconductor device and the substrate; sintering the semiconductor device and the substrate together by applying heat and pressure to the layer; wherein the heat and pressure are applied by a gas that surrounds the semiconductor device and the substrate and/or stack.

For example, the sintering may be performed in an oven that is filled with a heated and pressurized gas. A commercially available high temperature gas pressure sintering oven may be used for the sintering process. Because an isostatic (spatially homogenous) pressure may be provided by the gas, many assemblies with complex geometry may be sintered in one step, lowering the danger of ceramic or chip cracking. Because the heat capacity of a gas is smaller than that of oil, the temperature and pressure control may be more accurate and much faster than for an oil press. The sintering cycle time may be much shorter compared to an oil press. Additionally, there is no contamination of the assembly when using a gas as the pressure medium.

According to an embodiment of the invention, the metallic particles are silver nano particles. The metallic particles may be nano particles, which may have an average diameter of less than 100 nm. The metallic particles may be silver particles. It is possible that the sintering is performed with silver particles that are not nano particles.

According to an embodiment of the invention, the metallic particles are deposited in the form of a paste. It is possible that the metallic particles are mixed with further compounds such that they have a higher adherence to each other and to the bonding area they are deposited to.

According to an embodiment of the invention, the metallic particles are provided as a foil/film. In other words, a foil/film containing the metallic particles may be placed between the semiconductor device and the substrate.

According to an embodiment of the invention, the gas has a temperature below 500° C during the sintering. For example, for the sintering of silver nano particles, the temperature may be between 200°C to 350° C. In particular, the sintering takes place at a temperature lower than the melting temperature of the metallic particles, which for example is 960° C for silver.

According to an embodiment of the invention, the pressure is more than 2 MPa. For example, for sintering silver particles (being not nano particles) a pressure above 15 MPa may be necessary. For silver nano particles, the pressure may be between 3 and 10 MPa.

According to an embodiment of the invention, the gas is an inert gas. The gas may be nitrogen or argon. During the sintering process, when the pressure and the temperature of the gas are raised, the aggregate state of the gas does not change. After the sintering, for example when the assembly of semiconductor device and substrate is removed from the oven, the gas simply may be evacuated to the environment leaving no contamination on the assembly.

According to an embodiment of the invention, the method further comprises the step of: enclosing the semiconductor device and the substrate with a flexible bag that is impermeable to the gas during the sintering. The bag may be a soft, flexible cover that on the one hand may keep the components in position in its interior (i.e. the semiconductor device, the substrate, the particle layer), and that on the other hand may protect the components from the gas.

According to an embodiment of the invention, the bag is made of a thin metal sheet, or of a polymeric (e.g. PTFE) foil. In general, the material of the bag has to be flexible enough to wrap around the assembly of semiconductor device and substrate, and/or has to withstand the temperature of the sintering step.

According to an embodiment of the invention, the method further comprises the step of: evacuating the interior of the bag before the sintering. For example, the assembly of semiconductor device and substrate may be put in the bag, and after that the air may be exhausted from the bag until no or nearly no air is left in the bag after that the bag may be sealed. No gases inside the bag have to be pressurized during the sintering. Furthermore, the pressure of the outer atmosphere will press the components inside the bag together and thus will fix them during transport.

According to an embodiment of the invention, at least two semiconductor devices are positioned on the substrate, and the at least two semiconductor devices are sintered simultaneously. The at least two semiconductor devices may be positioned on one side of the substrate. In such a way, an assembly comprising a plurality of semiconductor devices may be formed in one process step.

The assembly may comprise more than one substrate. The above described substrate may be a first substrate.

According to an embodiment of the invention, the method further comprises the steps of: positioning a further (second) substrate on an opposite side of the (first) substrate and/or the semiconductor device; depositing a further layer of metallic particles between the further substrate and the substrate and/or the semiconductor device; and sintering the semiconductor device, the substrate and the further substrate simultaneously. For example, a bipolar semiconductor device may be sintered between two substrates. Also, a semiconductor device may be sintered on a first substrate, which is simultaneously sintered on a second substrate (which may be a baseplate).

According to an embodiment of the invention, the method further comprises the steps of: positioning a plurality of assemblies of semiconductor devices, assembly layers and substrates into a sintering device; sintering the plurality of assemblies in the sintering device simultaneously. The sintering device may comprise a heating device for heating the gas to the above mentioned temperature, and a pressurizing device for pressurizing the gas to the above mentioned pressure. The sintering device may be seen as a gas pressure sintering oven. With the sintering device a batch process for sintering a plurality of assemblies may be performed.

According to an embodiment of the invention, the substrate comprises ceramics material. In particular, a ceramics material may be very brittle and susceptible to cracks. With the method, the danger of cracks may be reduced significantly.

According to an embodiment of the invention, the substrate comprises a metallization on one or several sides, and the layer of metallic particles is deposited on the metallization. For example, the metallization may be a structured copper layer that does not extend over the complete side of the substrate.

According to an embodiment of the invention the substrate is made of metal or a metal alloy. It is also possible that the substrate is a metal plate, for example a base plate of the assembly.

According to an embodiment of the invention, the semiconductor device and/or the substrate may comprises at least one surface that is beveled with respect to the bonding area of the semiconductor device and/or the substrate. For example, the substrate or the semiconductor device may comprise a beveled edge that, for example, is used for forming the electrical field inside the assembly. Such edges and beveled surfaces may be the starting points for cracks.

In this context it has to be noted that a semiconductor devices may be rectangular and/or cuboid shaped. However, it is also possible that a semiconductor device may also have a round shape, when viewed from above.

According to an embodiment of the invention, facing sides of the semiconductor device and the substrate, which are sintered together, do not have the same extension. For example, the bonding area of the semiconductor device may be smaller than the substrate. Also in this case, sharp edges may be generated that may be starting point for cracks, when pressure is applied inhomogenously. With the method, the pressure is applied homogenously from all sides via the gas, and the danger of cracks is reduced.

Summarized, a high temperature gas pressure sintering oven may be used for a nano-Ag sintering process, for example for chip sintering to a substrate, substrate sintering for an assembly comprising more than one substrate and/or sintering of a bipolar semiconductor device (i.e. a semiconductor device having bonding areas on opposite sides). The high pressure sintering may be performed with any kind of beveling. The method may lead to a higher production yield, less process steps, a higher throughput and/or lower production costs.

These and other aspects of the invention will be apparent from and be elucidated with reference to the embodiments described hereinafter.

### Brief description of the drawings

The subject-matter of the invention will be explained in more detail in the following text with reference to exemplary embodiments which are illustrated in the attached drawings.
Fig.1 shows a schematic cross-section of an assembly with two chips and a substrate, manufactured according to an embodiment of the invention.
Fig. 2 shows a schematic cross-section of an assembly with several chips and several substrates, manufactured according to an embodiment of the invention.
Fig. 3 shows a schematic cross-section of an assembly with a chip and a substrate, manufactured according to an embodiment of the invention.
Fig. 4 shows a sintering device for manufacturing the assemblies as shown in Figs. 1 to 3 according to an embodiment of the invention.
Fig. 5 shows a flow diagram for a method of bonding an electronics chip to a substrate according to an embodiment of the invention.

In principle, identical parts are provided with the same reference symbols in the figures.

### Detailed description of exemplary embodiments

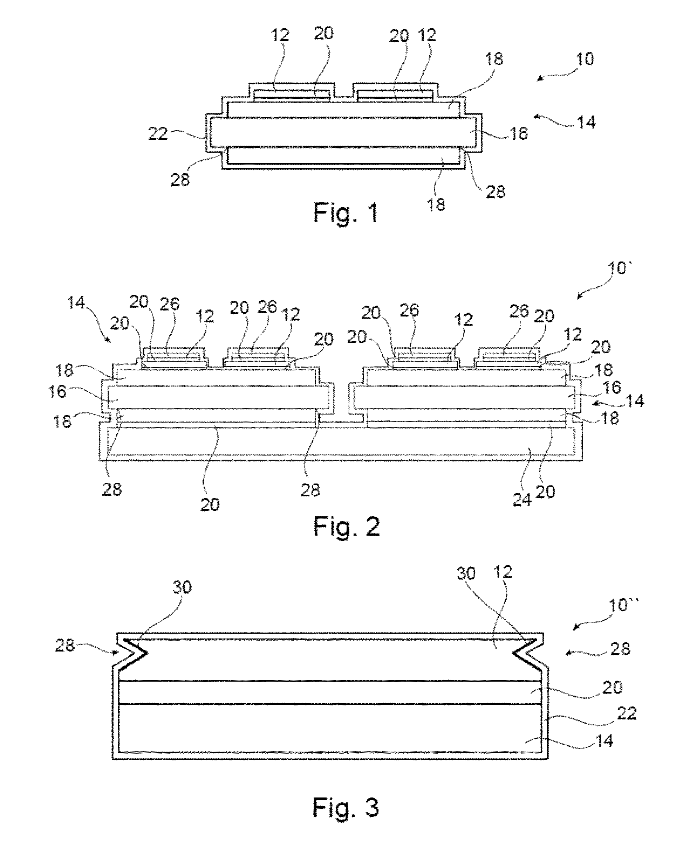

Fig. 1 shows an assembly or package 10 with two chips 12 and a substrate 14. For example, the chip 12 may contain a high power semiconductor, and the assembly 10 may be a power module that may be used in a power electronics device. In general, the chip 12 may be replaced by a semiconductor device in the following discussion.

Each of the chips 12 may be made of silicon (Si), SiC or another wide band gap semiconductor. Each chip 12 may be an IGBT die. The substrate 14 may comprise a core of ceramics 16, for example AlN, Al203, Si3N4, which comprises two metallization layers 18 on each side. The layers 18 may be made of copper (Cu) or aluminium (Al). The ceramics layer 16 may be insulation.

The chips 12 are attached on the ceramics substrate 14 via a sintered layer 20 as explained in the above and in the following. The assembly 10 shown in Fig. 1 is covered by a bag 22 that is used to protect the components 12, 14, 20 of the package during the sintering.

Fig. 2 shows a more complicated assembly 10' that comprises two of the assemblies 10 of Fig. 1 that are sintered to a further substrate 24, a base plate 24 of, for example, copper or AlSiC. As an additional substrate 26, each chip 12 is sintered to a top emitter plate 26.

Fig. 3 shows a further example for an assembly 10", in which the chip 12, which is a bipolar wafer, is sintered to a substrate 14, which is made of molybdenum (Mo). The bipolar wafer 12 comprises beveled edges 28, which may comprise DLC (diamond-like carbon) edge termination coatings 30.

These edges 28, as well as edges 28 of the other assemblies 10, 10' may be susceptible to cracks that may be produced, when the assemblies would be produced in a heated press that generates the pressure with pressing plates.

For example with respect to Fig. 1 and 2, usually the metallization 18 of the substrate 14 is smaller than the ceramics layer 16, due to insulation and power distribution requirements. This generates a critical point 28 or edge 28 that may be the starting point for cracks.

For all the assemblies 10, 10', 10" it may be difficult to apply a homogenous pressure from the top when pressing the chip 12 from the top.

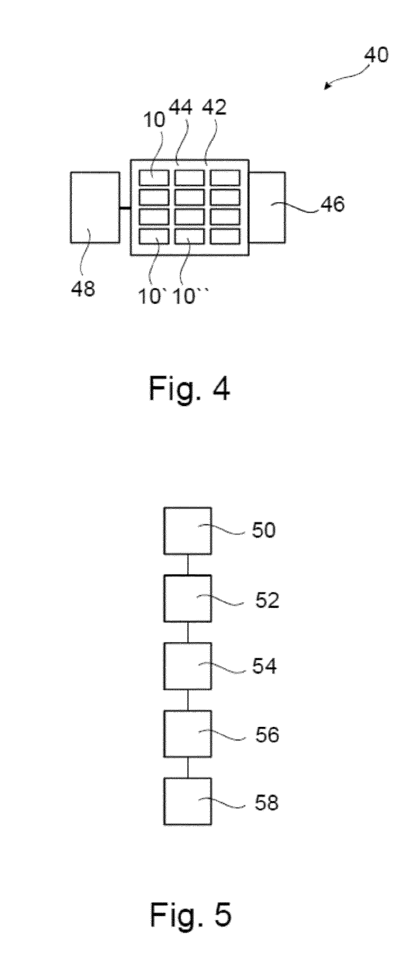

Fig. 4 shows a sintering device or oven 40, in which a plurality of assemblies 10 (or 10' or 10") may be placed and simultaneously sintered. The sintering device 40 comprises an interior volume 42, that may be filled with a gas 44 that completely surrounds each of the assemblies 10, a heating device 46 for heating the gas 44, and a pressurizing device 48 for pressurizing the gas 44 to the desired high pressure.

For example, high temperature gas pressure sintering ovens 40 are commercially available that may have a volume of up to 1100 dm³ and may be adapted for generating a pressure up to 10 MPa with N₂-gas 44 or Ar-gas 44. The pressure of such an oven 40 is high enough for a nano-Ag sintering process (5 to 10 MPa) and the volume is also large enough for a batch process in mass production.

The method for manufacturing the assembly will be explained with respect to Fig. 5.

In step 50, a layer 20 of metallic particles is deposited on the bonding area of the chips 12 and/or of the substrate 14. For example, silver nano particles may be applied in the form of a paste that is deposited on all interfaces or bonding areas that have to be attached to each other. The particles also may be applied in the form of a powder, a film or within a foil.

In step 52, the chip 12 is positioned on the substrate 14, such that the layer 20 is positioned between the chip 12 and the substrate 14. For example, a positioning of the chip 12 and the substrate 14 may be facilitated by a tagging effect provided by the layer of metallic particles. Also additional positioning fixtures like positioning pins may be used.

With respect to Fig. 2, during steps 50 and 52 also further substrates 24, 26 may be positioned on an opposite side of the substrate 14 and the chips 12, and further layers 20 of metallic particles may be deposited between the further substrates 24, 26, the substrate 14, and the chips 12.

For example, the top emitter plates 26 may be placed on top of the chips 12, the chips 12 may be placed on the ceramics substrates 14, and the substrates 14 may be placed on the base plate 24.

In step 54, the chips 12 and the substrate 14 (and optionally 24, 26) are enclosed with a flexible bag 22 that is impermeable to the gas 44. The bag 22 may be evacuated and the assembly 10, 10', 10" may be sealed into the bag 22. For example, a soft, flexible bag 22 made of plastic (e.g. PTFE) or a thin metal foil may be used to seal all the components 12, 14, 24, 26 that need to be sintered together. The bag 22 may adapt to the final complex geometry, as shown in Figs. 1, 2 and 3. The bag 22 may be used for maintaining the positioning of the components of the assembly 10, 10' 10". Furthermore, the bag may be used for protecting the components. For example, the DLC edge termination coating 30 may be very critical to contamination.

In step 56, a plurality of assemblies 10, 10', 10" are put into a sintering device 40. For example, the assemblies 10, 10', 10" may be transferred to the gas sintering oven 40 in their flexible bags 22.

In step 58, the chips 12 and the substrate 14 are sintered together by applying heat and pressure to the layers 20. The heat and pressure are applied by the gas 44 that surrounds the assemblies 10, 10', 10" in the bag 22.

With many assemblies 10, 10', 10" in the gas sintering oven 40 a batch process may be established. The plurality of assemblies 10, 10', 10" may sintered simultaneously. Also all interconnections between the chips 12 and substrates 14, 24, 26 may be sintered in one step.

After the fully sintered packages 10, 10', 10" have been removed from the sintering device 40, the bags 22 may be removed.

With the method, an IGBT chip 12 may be attached to a ceramics substrate 14 (see Fig. 1), a complete IGBT module 10' may be fully sintered (see Fig. 2), or a bipolar wafer 12 with complex beveling edges 28 may be attached to a Mo disc 14 (see Fig. 3) in only one sintering process.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

**List of references**

| | |
|---|---|
| 10, 10', 10" | assembly |
| 12 | semiconductor device, chip |
| 14 | substrate |
| 16 | ceramics layer |
| 18 | metallization layer |
| 20 | layer of metallic particles, sintered layer |
| 22 | bag |
| 24 | further substrate |
| 26 | further substrate |
| 28 | edge |
| 30 | edge termination coating |
| 40 | sintering device |
| 42 | interior volume |
| 44 | gas |
| 46 | heating device |
| 48 | pressurizing device |
| 50, 52, 54, 56, 58 | steps |

## Claims

1. A method of bonding a semiconductor device (12) to a substrate (14), the method comprising the steps of:
depositing a layer (20) of metallic particles on a bonding area of the semiconductor device (12) and/or of the substrate (14);
positioning the semiconductor device (12) on the substrate (14), such that the layer (20) is positioned between the semiconductor device (12) and the substrate (14);
sintering the semiconductor device (12) and the substrate (14) together by applying heat and pressure to the layer (20);
wherein the heat and pressure are applied by a gas (44) that surrounds the semiconductor device (12) and the substrate (14).

2. The method of claim 1,
wherein the gas has a temperature below 500° C during the sintering.

3. The method of claim 1 or 2,
wherein the pressure is more than 2 MPa.

4. The method of one of the preceding claims,
wherein the gas (44) is an inert gas, such as nitrogen or argon.

5. The method of one of the preceding claims,
wherein the metallic particles are silver nano particles; and/or
wherein the metallic particles are provided in the form of a paste or in a foil.

6. The method of one of the preceding claims, further comprising the step of:
enclosing the semiconductor device (12) and the substrate (14) with a flexible bag (22) that is impermeable to the gas (44) during the sintering.

7. The method of claim 6,
wherein the bag (22) is made of a polymer foil or a metal sheet.

8. The method of claim 6 or 7, further comprising the step of:
evacuating the interior of the bag (22) before the sintering.

9. The method of one of the preceding claims,
wherein at least two semiconductor devices (12) is positioned on the substrate (14) and the at least two semiconductor devices (12) are sintered simultaneously.

10. The method of one of the preceding claims, further comprising the steps of:
positioning a further substrate (24, 26) on an opposite side of the substrate (14) and/or the semiconductor device (12);
depositing a further layer (20) of metallic particles between the further substrate (24, 26) and the substrate (14) and/or the semiconductor device (12);
sintering the semiconductor device (12), the substrate (14) and the further substrate (24, 26) simultaneously.

11. The method of one of the preceding claims, further comprising the steps of:
positioning a plurality of assemblies of semiconductor devices, assembly layers and
substrates into a sintering device;
sintering the plurality of assemblies in the sintering device simultaneously.

12. The method of one of the preceding claims,
wherein the substrate comprises ceramics material; and/or
wherein the substrate comprises a metallization on a side, and the layer is deposited on the metallization.

13. The method of one of the preceding claims,
wherein the substrate is made of metal or a metal alloy.

14. The method of one of the preceding claims,
wherein the semiconductor device and/or the substrate comprises at least one surface that is beveled with respect to the bonding area of the semiconductor device and/or the substrate.

15. The method of one of the preceding claims,
wherein facing sides of the semiconductor device and the substrate, which are sintered together, do not have the same extension.
